# EUROPÄISCHE PATENTSCHRIFT

(11) **EP 0 573 441 B1**
(45) Veröffentlichungstag und Bekanntmachung des Hinweises auf die Patenterteilung: **10.05.1995**
(21) Anmeldenummer: 92903884.2
(22) Anmeldetag: 10.02.1992
(51) Int. Cl.: H05K 9/00, H05K 7/14

(54) **GESCHIRMTER BAUGRUPPENTRÄGER FÜR EINSCHIEBBARE ELEKTRISCHE BAUGRUPPEN**
SHIELDING SUPPORT FOR PLUG-IN ELECTRIC COMPONENTS
SUPPORT BLINDE DE COMPOSANTS ELECTRIQUES ENFICHABLES

(30) Priorität: 28.02.1991 EP 91103030
(43) Veröffentlichungstag der Anmeldung: 15.12.1993
(73) Patentinhaber: SIEMENS AKTIENGESELLSCHAFT, 80333 München (DE)
(72) Erfinder: SEDLMEIER, Peter Dipl.-Ing., D-81669 Müunchen (DE)
(86) Internationale Anmeldenummer: EP9200287
(87) Internationale Veröffentlichungsnummer: WO9216093

(56) Entgegenhaltungen:
- DE-A- 3 112 595
- DE-A- 3 438 702
- DE-U- 1 912 064
- DE-U- 1 976 658
- RESEARCH DISCLOSURE, Nr. 288, April 1988, Seite 202, New York, NY, US; Referat 28823: "Interlocking cover"

## Beschreibung

Die Erfindung bezieht sich auf einen Baugruppenträger für einschiebbare elektrische Baugruppen mit sich parallel zu diesen erstreckenden, aus Blech bestehenden Seitenwänden.

Ein derartiger Baugruppenträger ist z. B. durch die DE-OS 31 12 595 bekannt geworden. Danach sind zwischen den beiden Seitenwänden Tragschienen angeordnet, die zusammen mit diesen einen festen Rahmen bilden. In diesen können von der Frontseite her die Baugruppen eingeschoben werden. Der Baugruppenrahmen weist auf seiner Rückseite Steckerleisten auf, in die die entsprechenden Gegenstecker der Baugruppen eingesteckt werden. Eine Rückwandverdrahtungsplatte ermöglicht es, die verschiedenen Baugruppen eines Rahmens miteinander zu verbinden. Die aus Blech bestehenden Seitenwände weisen herausgebogene Laschen auf, die mit Befestigungslöchern zum Anschrauben an ein Schrankgestell versehen sind.

Es ist üblich, derartige Baugruppenmagazine auf ihrer Oberseite und ihrer Unterseite mit Schirmblechen zu versehen, die mit den Seitenwänden über dazwis-chenliegende Dichtungsstreifen aus Kontaktfedermaterial elektrisch verbunden sind. Ein solches Magazin läßt sich mittels geerdeter Frontblenden und Erdungslagen in der Rückwandverdrahtung gegen elektrische und magnetische Störstrahlungen abschirmen. Zwischen den Schirmblechen und den Seitenwänden ergeben sich jeweils zwei elektrische Übergänge. Die Bleche und die Dichtungsstreifen bestehen aus unterschiedlichem Material, wodurch die Korrosionsgefahr an den Stoßstellen steigt.

Der Erfindung liegt die Aufgabe zugrunde, den Herstellungsaufwand für das Magazin zu verringern und die Schirmwirkung zu verbessern.

Diese Aufgabe wird durch die Erfindung gemäß Anspruch 1 gelöst. Die einfach herzustellenden, L-förmig gebogenen Gehäuseteile können unmittelbar im Überlappungsbereich miteinander kontaktiert und mechanisch verbunden werden. Es ergibt sich ein Minimum an elektrischen Übergängen, bei denen gleiche Materialien aneinander liegen, wodurch die Korrosionsgefahr gering gehalten wird. Als Verbindungsmittel kommen z. B. Punktschweißen, Nieten, Löten oder Schrauben in Betracht. Die Verbindungspunkte können z. B. in einem frequenzabhängigen Abstand von 25 mm angeordnet werden. Derartige Verbindungen weisen einen sehr geringen elektrischen Übergangswiderstand auf, so daß die Schirmwirkung erheblich verbessert wird. Die Verbindungsstellen erstrecken sich entlang lediglich zweier Seitenkanten des Baugruppenrahmens, so daß die Anzahl der Übergänge gering bleibt.

Die L-förmig gebogenen Gehäuseteile haben einen geringen Materialverbrauch und sind von identisch gleicher Form. Sie können im fertig gebogenen Zustand platzsparend gestapelt werden. Durch die Abbiegungen sind die Gehäuseteile in sich so stabil, daß sie einen großen Teil der auftretenden mechanischen Belastungen aufnehmen können.

Vorteilhafte Weiterbildungen der Erfindung sind in den Ansprüchen 2 bis 10 gekennzeichnet:

Durch die Weiterbildung nach Anspruch 2 werden die Gehäuseteile an der Rückseite erheblich versteift und bilden zugleich Anschlagflächen für die Rückwandplatte.

Die Weiterbildung nach Anspruch 3 ergibt eine frontseitige Versteifung der Gehäuseteile, die durch die Maßnahmen nach Anspruch 4 noch verstärkt wird.

Durch die Weiterbildung nach Anspruch 5 ist es möglich, den Baugruppenträger wirksam zu kühlen. Auf das Ausschneiden großer Durchbrüche in den Gehäuseteilen und die zusätzliche Anbringung von Gitterblechen kann verzichtet werden. Die Lochabstände lassen sich optimal auf die Schirmanforderungen einstellen.

Durch die Verbindungsschrauben nach Anspruch 6 lassen sich die Gehäuseteile und die Rückwandplatte günstig montieren und elektrisch verbinden.

Die Weiterbildung nach Anspruch 7 macht sich die besonders gute Leitfähigkeit von Aluminium zu Nutze. Die selbstfurchenden Gewindeschrauben führen zu gasdichten Kontakten von hoher Güte. Besonders vorteilhaft verwendet man weiches Aluminium, das eine besonders gute Leitfähigkeit aufweist und sich gut verformen läßt. Eine umweltbelastende galvanische Oberflächenveredelung wird überflüssig, was die Herstellungskosten verringert. Das relativ dicke Aluminium ermöglicht eine gute Schirmung auch bei einem hohen Perforationsgrad.

Durch die Weiterbildung nach Anspruch 8 können die Masselagen der Rückwandplatte besonders günstig mit den Gehäuseteilen elektrisch verbunden wercen, indem z. B. die Schraubköpfe mittelbar oder unmittelbar mit den Masselagen kontaktiert werden. Dadurch wird ein Kontaktfederstreifen zwischen der Rückwandplatte und den-Gehäuseteilen überflüssig. Durch das Anschrauben der Rückwanaplatte wird außerdem der Eaugruppenträger zusätzlich versteift.

Die Weiterbildung nach Anspruch 9 ermöglicht eine besonders schirmungssichere Anbringung des Deckels. Dabei ist es insbesondere von Vorteil, den Kontaktfederstreifen an der Innenseite des Deckels formschlüssig anzubringen, um Handhabungsschäden weitgehend zu verhindern.

Die Weiterbildung nach Anspruch 10 ermöglicht die Anbringung von Haltewinkeln ohne schirmungsrelevante Öffnungen in den Seitenschenkeln der Gehäuseteile.

Im folgenden wird die Erfindung anhand eines in der Zeichnung dargestellten Ausführungsbeispiels näher erläutert.

Es zeigen:
- Fig. 1: schematisiert ein Gehäuseteil eines Baugruppenträgers in seiner Zuordnung zu einem strichpunktiert angedeuteten zweiten Gehäuseteil,
- Fig. 2: schematisiert einen Schnitt durch einen mit den Gehäuseteilen gebildeten Baugruppenträger,
- Fig. 3: eine frontseitige perspektivische Ansicht des Baugruppenträgers nach Figur 2,
- Fig. 4: eine rückseitige perspektivische Ansicht des Baugruppenträgers nach Figur 2.

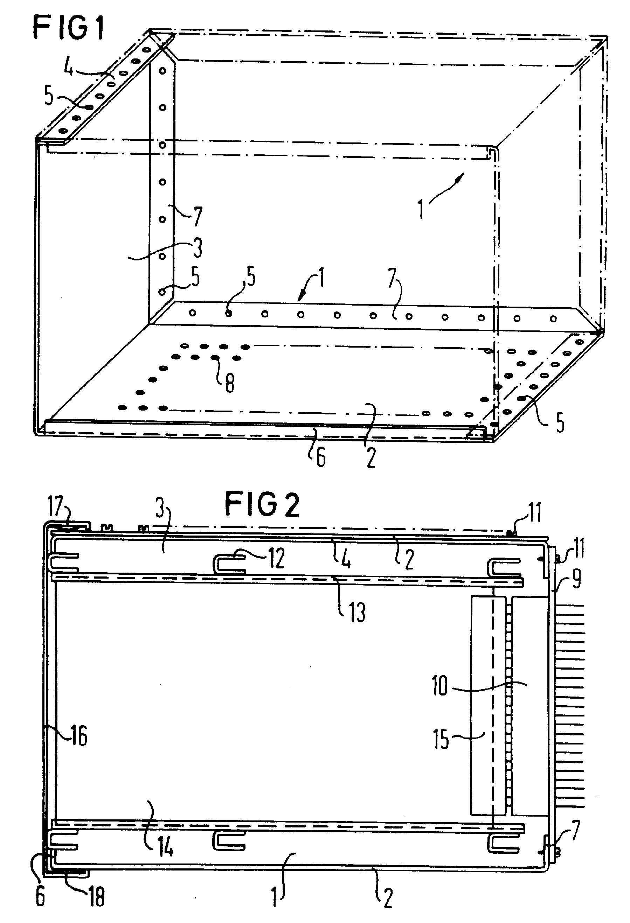

Figur 1 zeigt ein Gehäuseteil 1, das zusammen mit einem zweiten, strichpunktiert angedeuteten Gehäuseteil 1 ein Gehäuse eines Baugruppenträgers bildet. Das Gehäuseteil 1 besteht im wesentlichen aus einem L-förmig gebogenen Blech mit einem längeren waagerechten Schenkel 2 und einem kürzeren senkrechten Schenkel 3. Der senkrechte Schenkel 3 weist an seinem Ende einen streifenförmig abgebogenen Steg 4 auf, der in die gleiche Richtung wie der waagerechte Schenkel 2 weist. Er ist mit einer Reihe von Schraublöchern 5 versehen, die in einem Abstand angeordnet sind, der von der im Baugruppenträger herrschenden Frequenz abhängt. Am Ende des waagerechten Schenkels 2 ist eine weitere Reihe von Schraublöchern 5 vorgesehen, die sich parallel zur anderen Reihe erstreckt. Der waagerechte Schenkel 2 ist an seiner Frontseite zu einem kurzen Stützsteg 6 hochgebogen. Die Rückseiten der Schenkel 2, 3 weisen nach innen abgebogene Befestigungsstege 7 auf, die ebenfalls mit Schraublöchern 5 zum Anschrauben einer Rückwandplatte versehen sind.

Das zweite Gehäuseteil 1 ist zum ersten um eine waagerechte, sich parallel zu den Schenkeln 2, 3 erstreckende Achse drehsymmetrisch angeordnet. Es ergibt sich dadurch ein rechteckiges Gehäuse, bei dem sich die Gehäuseteile im Bereich der Verbindungsstege 4 derart überlappen, daß die beiden Reihen der Schraublöcher 5 in den Stegen 4 und an den Enden der langen Schenkel 2 zur Deckung kommen. Die Schraublöcher 5 sind so bemessen, daß die beiden Gehäuseteile durch selbstfurchende Gewindeschrauben mechanisch und elektrisch sicher miteinander verbunden werden können.

Die beiden gleichen Gehäuseteile 1 bestehen vorteilhaft aus weichem Aluminium, das im Bereich des waagerechten Schenkels 2 mit Luftlöchern 8 engmaschig perforiert ist. Die relativ große Materialdicke ermöglicht einen engen Lochabstand, ohne daß die mechanische Stabilität und die Schirmwirkung beeinträchtigt werden.

Figur 2 zeigt die Gehäuseteile 1 im montierten Zustand mit einer an die Befestigungsstege 7 angeschraubten Rückwandplatte 9, die senkrecht orientierte Stegverbinder 10 trägt. Die Rückwandplatte 9 ist als mehrlagige Leiterplatte ausgebildet, die auf ihrer Außenseite eine Masselage aufweist, die den Durchtritt von Störstrahlungen verhincert. Die Rückwandplatte 9 ist ebenfalls mit gewindefurchenden Schrauben 11 an den Gehäuseteilen 1 befestigt. Dabei sind die Köpfe der Schrauben 11 mit den Masselagen kontaktiert, so daß zwischen den Gehäuseteilen 1 und den Masselagen eine sichere elektrische Verbindung zustance kommt. Entlang der waagerechten Schenkel 2 erstrecken sich waagerechte Tragschienen 12, an denen schienenartige Führungen 13 für einschiebbare elektrische Baugruppen 14 gehalten sind. Die Führungen 13 erstrecken sich senkrecht zu den Tragschienen 12 von der Frontseite zur Rückseite der Gehäuseteile. Die Baugruppe ist mit einem rückseitigen Stecker 15 versehen, der mit dem Steckverbinder 10 kontaktiert ist.

Die Tragschienen 12 sind in nicht näher dargestellter Weise an den kurzen senkrechten Schenkeln 3 der Gehäuseteile 1 befestigt.

Die Stützstege 6 sind so bemessen, daß sie sich mit ihrer freien Längskante an den frontseitigen Tragschienen 12 abstützen, wodurch die Gehäuseteile 1 auch auf dieser Seite zusätzlich versteift werden. Ein frontseitig angesetzter Deckel 16 weist zur Rückseite hin abgebogene Ränder 17 auf, die die Gehäuseteile 1 von außen her umgreifen. Zwischen den Rändern 17 und den Schenkeln 2, 3 der Gehäuseteile 1 sind Kontaktfederstreifen 18 angeordnet, die den Deckel 16 elektrisch mit den Gehäuseteilen 1 verbinden. Die Kontaktfederstreifen halten außerdem den Deckel 16 kraftschlüssig an den Gehäuseteilen 1. Sie sind an den Innenseiten der Ränder 17 formschlüssig gehalten und vor Handhabungsbeschädigungen geschützt.

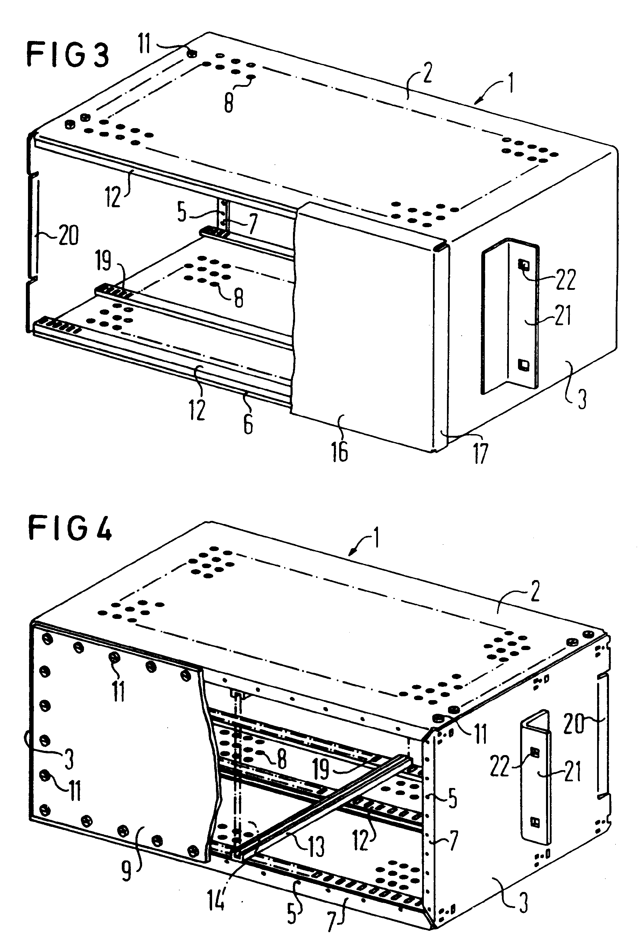

Die Figuren 2 und 3 zeigen den Baugruppenträger nach Figur 2 in perspektivischer Darstellung von der Frontseite (Figur 2) bzw. der Rückseite (Figur 3). Die Tragschienen 12 weisen Haltelöcher 19 zum Befestigen der Führungen 13 für die Baugruppen 14 auf. Die kurzen Schenkel 3 der Gehäuseteile 1 sind entlang ihrer Frontkante mit einer nach außen abgeschränkten Klemmlasche 20 versehen, die von den Kontaktfederstreifen 18 (Figur 2) federnd hintergriffen wird und zu einer sicheren Verrastung des Deckels 16 an den Gehäuseteilen 1 verhilft. An den senkrechten kurzen Schenkeln 3 sind z. B. durch Punktschweißen Haltewinkel 21 befestigt, die mit Befestigungslöchern 22 zum Anbringen des Baugruppenträgers an einem Schrankgestell versehen sind.

Erkennbar ist ferner die wannenartige Ausbildung des Deckels 16 mit seinen Rändern 17. Die Rückwandplatte 9 ist umlaufend an den Schraublöchern 5 der Befestigungsstege 7 angeschraubt. Sie stabilisiert dadurch die Gehäuseteile 1 gegen Verformung. Die Luftlöcher 8 sind engmaschig verteilt, so daß eine gute Kühlung der Baugruppen 14 möglich ist.

## Patentansprüche

1. Baugruppenträger für einschiebbare elektrische Baugruppen (14) mit sich parallel zu diesen erstreckenden, aus Blech bestehenden Seitenwänden (z. B. 3) sowie mit Mitteln zur Befestigung des Baugruppenträgers in einem Schrankgestell, wobei zwischen den Seitenwänden auf der Ober- und Unterseite des Baugruppenträgers Schirmbleche (z. B. 2) angeordnet sind, die mit den Seitenwänden kontaktiert sind,
**dadurch gekennzeichnet,**
daß die Schirmbleche und die Seitenwände Bestandteile zweier L-förmig gebogener Gehäuseteile (1) sind, die einander drehsymmetrisch gegenüberstehen und an ihren Enden miteinander verbunden sind und deren einander entgegenragende Schenkel (2, 3) die Seitenwände und die Schirmbleche bilden, daß zumindest einer der Schenkel (3) an seinem Ende einen streifenförmig abgebogenen Steg (4) aufweist, der den jeweils entgegenragenden Schenkel (2) des anderen Gehäuseteils (1) überlappt, und daß die beiden Gehäuseteile (1) in diesem Bereich eine Reihe von Verbindungspunkten aufweisen.

2. Baugruppenträger nach Anspruch 1,
**dadurch gekennzeichnet,**
daß die Gehäuseteile (1) rückseitig entlang der Schenkel (2, 3) nach innen rechtwinklig abgebogene Befestigungsstege (7) mit einer Vielzahl von Befestigungsstellen für eine Rückwandplatte (9) aufweisen.

3. Baugruppenträger nach Anspruch 1 oder 2,
**dadurch gekennzeichnet,**
daß an den Gehäuseteilen (1) entlang ihrer waagerechten Schenkel (2) frontseitig recht inklig abgebogene Stützstege (6) ausgebildet sind.

4. Baugruppenträger nach Anspruch 1, 2 oder 3,
**dadurch gekennzeichnet,**
daß schienenartige Führungen (13) für einzelne Baugruppen (14) an waagerechten Tragschienen (12) gehalten sind, die sich parallel zur Frontseite des Baugruppenträgers entlang des oberen und unteren langen Schenkels (2) der Gehäuseteile (1) erstrecken und daß sich die frontseitigen Stützstege (6) an den frontseitigen Tragschienen (12) abstützen.

5. Baugruppenträger nach einem der vorhergehenden Ansprüche,
**dadurch gekennzeichnet,**
daß die waagerechten Schenkel (2) der Gehäuseteile (1) engmaschig perforiert sind.

6. Baugruppenträger nach einem der vorhergehenden Ansprüche,
**dadurch gekennzeichnet,**
daß die Gehäuseteile (1) miteinander an den Verbindungspunkten verschraubt sind und daß die Rückwandplatte (9) an den rückseitigen Befestigungsstegen (7) angeschraubt ist.

7. Baugruppenträger nach einem der vorhergehenden Ansprüche,
**dadurch gekennzeichnet,**
daß die Gehäuseteile (1) aus weichem Aluminium bestehen und mittels selbstfurchenden Schrauben (11) miteinander und mit der Rückwandplatte (9) verbunden sind.

8. Baugruppenträger nach Anspruch 7,
**dadurch gekennzeichnet,**
daß die Rückwandplatte (9) als gedruckte Leiterplatte ausgebildet ist, die auf der Außenseite des Baugruppenträgers zumindest eine Masselage aufweist, daß die Rückwandplatte (9) mit den selbstfurchenden Schrauben (11) an die Befestigungsstege (7) angeschraubt ist und daß die Schrauben (11) mit der Masselage kontaktiert ist.

9. Baugruppenträger nach einem der vorhergehenden Ansprüche,
**dadurch gekennzeichnet,**
daß die Frontseite des Baugruppenträgers mit einem wannenähnlichen Deckel (16) verschließbar ist, der mit seinen Rändern (17) die Gehäuseteile (1) von außen umgreift und daß zwischen den Rändern (17) und den Gehäuseteilen (1) umlaufende Kontaktfederstreifen (18) angeordnet sind.

10. Baugruppenträger nach einem der vorhergehenden Ansprüche,
**dadurch gekennzeichnet,**
daß an den senkrechten Schenkeln (3) der Gehäuseteile (1) Haltewinkel (21) zum Befestigen des Baugruppenträgers an einem Schrankgestell angebracht sind.

## Claims

1. Subassembly rack for push-in electrical subassemblies (14), having side walls (for example 3) which extend parallel to said subassemblies and consist of sheet metal, as well as having means for fastening the subassembly rack in a cabinet frame, screening plates (for example 2) that are contacted to the side walls being arranged between the side walls on the topside and underside of the subassembly rack, characterised in that the screening plates and the side walls are components of two housing parts (1) which are bent in the shape of an L, oppose one another in a rotationally symmetrical fashion, are connected to one another at their ends, and whose mutually oppositely projecting limbs (2, 3) form the side walls and the screening plates, in that at least one of the limbs (3) has at its end a web (4) which is bent in the shape of a strip and overlaps the respectively oppositely projecting limb (2) of the other housing part (1), and in that the two housing parts (1) have a row of junction points in this region.

2. Subassembly rack according to Claim 1, characterised in that at the rear along the limbs (2, 3) the housing parts (1) have fastening webs (7) which are bent inwards at right angles and have a multiplicity of fastening points for a backplane (9).

3. Subassembly rack according to Claim 1 or 2, characterised in that supporting webs (6) bent at right angles frontally are constructed on the housing parts (1) along their horizontal limbs (2).

4. Subassembly rack according to Claim 1, 2 or 3, characterised in that rail-like guides (13) for individual subassemblies (14) are held on horizontal mounting rails (12) which extend parallel to the front of the subassembly rack along the upper and lower long limb (2) of the housing parts (1), and in that the frontal supporting webs (6) are supported on the frontal mounting rails (12).

5. Subassembly rack according to one of the preceding claims, characterised in that the horizontal limbs (2) of the housing parts (1) are perforated in a close mesh.

6. Subassembly rack according to one of the preceding claims, characterised in that the housing parts (1) are screwed together at the junction points, and in that the backplane (9) is screwed onto the rear fastening webs (7).

7. Subassembly rack according to one of the preceding claims, characterised in that the housing parts (1) consist of soft aluminium and are connected to one another and to the backplane (9) by means of self-tapping screws (11).

8. Subassembly rack according to Claim 7, characterised in that the backplane (9) is constructed as a printed circuit board which has at least one earthing layer on the outside of the subassembly rack, in that the backplane (9) is screwed onto the fastening webs (7) by means of the self-tapping screws (11), and in that the screws (11) are contacted to the earthing layer.

9. Subassembly rack according to one of the preceding claims, characterised in that the front of the subassembly rack can be sealed with a trough-like cover (16) which surrounds the housing parts (1) from outside with its rims (17), and in that circumferential contact spring strips (18) are arranged between the rims (17) and the housing parts (1).

10. Subassembly rack according to one of the preceding claims, characterised in that retaining angles (21) for fastening the subassembly rack to a cabinet frame are provided on the vertical limbs (3) of the housing parts (1).

## Revendications

1. Porte-modules pour des modules électriques enfichables (14), comportant des parois latérales (par exemple 3) qui s'étendent parallèlement à ces modules et qui sont en tôle, ainsi que des moyens de fixation du porte-modules dans un bâti d'armoire, des tôles de protection (par exemple 2), qui sont en contact avec les parois latérales, étant disposées entre les parois latérales de la face supérieure et de la face inférieure du porte-modules, caractérisé le fait que les tôles de protection et les parois latérales sont des éléments constitutifs de deux parties de boîtier (1) coudées en forme de L, qui sont situées symétriquement en vis-à-vis l'une de l'autre et qui sont reliées entre elles à leurs extrémités et dont les branches (2,3), qui se rejoignent mutuellement forment les parois latérales et les tôles de protection, qu'au moins l'une des branches (3) possède, à son extrémité, une barrette (4) coudée en forme de bande, qui chevauche l'une (2) des branches qui se rejoignent, de l'autre partie de boîtier (1) et que les deux parties de boîtier (1) comportent, dans cette zone, une série de points de liaison.

2. Porte-modules suivant la revendication 1, caractérisé par le fait que les parties de boîtier (1) comportent sur la face arrière, le long des branches (2,3), des barrettes de fixation (7) qui sont coudées à angle droit vers l'intérieur et qui comportent une multiplicité de points de fixation pour une plaque de paroi arrière (9).

3. Porte-modules suivant la revendication 1 ou 2, caractérisé par le fait que des barrettes de support (6), qui sont coudées frontalement à angle droit, sont formées sur les parties de boîtier (1) le long de leur branche (2) horizontale.

4. Porte-modules suivant la revendication 1, 2 ou 3, caractérisé par le fait que des guides en forme de rails (13) pour différents modules (14) sont retenus sur des rails horizontaux de support (12), qui s'étendent parallèlement à la face frontale du porte-modules le long des longues branches (2) supérieure et inférieure des parties de boîtier (1), et que les barrettes d'appui frontales (6) prennent appui sur les rails de support frontaux (12).

5. Porte-modules suivant l'une des revendications précédentes, caractérisé par le fait que les branches horizontales (2) des parties de boîtier (1) sont perforées selon un réseau à mailles étroites.

6. Porte-modules suivant l'une des revendications précédentes, caractérisé par le fait que les parties de boîtier (1) sont vissées l'une à l'autre au niveau de points de liaison et que la plaque de paroi arrière (9) est vissée sur les barrettes de fixation (7) situées sur la face arrière.

7. Porte-modules suivant l'une des revendications précédentes, caractérisé par le fait que les parties de boîtier (1) sont en aluminium mou et sont reliées entre elles et à la plaque de paroi (9) par des vis autotaraudeuses (11).

8. Porte-modules suivant la revendication 7, caractérisé par le fait que la plaque de paroi arrière (9) est réalisée sous la forme d'une plaquette à circuits imprimés, qui possède, sur la face extérieure du porte-module, au moins un point de masse, que la plaque de paroi arrière (9) est vissée au moyen des vis autotaraudeuses (1) sur la barrette de fixation (7) et que les vis (11) sont en contact avec le point de masse.

9. Porte-modules suivant l'une des revendications précédentes, caractérisé par le fait que la face avant du porte-modules peut être fermée par un couvercle (16) semblable à une cuvette et dont les bords (17) entourent extérieurement les parties de boîtier (1) et que des bandes élastiques de contact (18) sont disposées entre les bords (17) et les parties de boîtier (1).

10. Porte-modules suivant l'une des revendications précédentes, caractérisé par le fait que sur les branches (3) verticales des parties de boîtier (1) sont disposées des cornières de fixation (21) servant à fixer le porte-modules sur un châssis d'armoire.
